# EUROPEAN PATENT APPLICATION

(11) **EP 4 836 430 A1**
(43) Date of publication of application: **04.11.2026**
(21) Application number: 24918419.3
(22) Date of filing: 24.12.2024
(51) Int. Cl.: H04N 23/52, G03B 17/02, G03B 17/55, H05K 7/20

(54) **IMAGING DEVICE**

(30) Priority: 16.01.2024 JP 2024004412
(71) Applicant: Sony Group Corporation, Tokyo 108-0075 (JP)
(72) Inventor: MEGURO, Hiroyuki, Tokyo 108-0075 (JP); MAKINO, Takuya, Tokyo 108-0075 (JP); HIROTA, Toshihiko, Tokyo 108-0075 (JP); KAMBARA, Makoto, Tokyo 108-0075 (JP); HANJO, Manabu, Tokyo 108-0075 (JP)
(74) Representative: D Young & Co LLP
(86) International application number: PCT/JP2024/045730
(87) International publication number: WO 2025/154507

(57) **Abstract**

An imaging device includes: a cooling fan in which a rotary blade is disposed inside a housing, an axial direction of a rotary shaft of the rotary blade is a thickness direction, and an intake opening is formed on at least one surface portion in the thickness direction; a first heat sink that includes a plurality of first heat dissipation fins, and causes cooling air to flow through a first flow path toward the intake opening; and a second heat sink that includes a plurality of second heat dissipation fins, and causes cooling air to flow through a second flow path toward the intake opening, the first heat sink and the second heat sink are disposed at different positions in a direction orthogonal to the thickness direction, and the first flow path and the second flow path are spaces different from each other.

## Description

### TECHNICAL FIELD

The present technology relates to a technical field of an imaging device including a cooling fan and a heat sink.

### BACKGROUND ART

Various imaging devices such as video cameras or still cameras include heat generating components such as various substrates in addition to an imaging element such as a charge coupled device (CCD) or a complementary metal oxide semiconductor (CMOS), and it is necessary to restrain a rise in temperature due to heat generation of these heat generating components and secure an appropriate driving state.

In view of the above, some imaging devices are provided with a cooling structure in which a cooling fan (a sirocco fan) and a heat sink are disposed in a case body in order to restrain a rise in temperature due to heat generation of a heat generating component (see, for example, Patent Document 1).

It has been described that the imaging device described in Patent Document 1 is provided with a cooling fan, a first heat sink, and a second heat sink, and cooling air taken in from an intake opening of a case body sequentially passes through the first heat sink and the second heat sink, is sucked into the cooling fan, is blown out from the cooling fan, and is discharged from an exhaust opening.

### CITATION LIST

### PATENT DOCUMENT

Patent Document 1: Japanese Patent Application Laid-Open No. 2016-201798

### SUMMARY OF THE INVENTION

### PROBLEMS TO BE SOLVED BY THE INVENTION

Incidentally, the imaging device having the cooling structure, as described above, is provided with various heat generating components, as described above, and thus it is desirable to increase cooling efficiency to sufficiently restrain a rise in temperature due to the heat generation of the heat generating components and ensure an appropriate driving state. In particular, in a configuration in which a plurality of heat sinks is provided, it is desirable that each of the heat sinks sufficiently exchange heat with the cooling air to improve cooling efficiency.

In view of the above, an object of an imaging device according to the present technology is to improve cooling efficiency without increasing the sizes of components.

### SOLUTIONS TO PROBLEMS

An imaging device according to the present technology includes: a cooling fan in which a rotary blade is disposed inside a housing, an axial direction of a rotary shaft of the rotary blade is a thickness direction, and an intake opening is formed on at least one surface portion in the thickness direction; a first heat sink that includes a plurality of first heat dissipation fins, and causes cooling air to flow through a first flow path toward the intake opening; and a second heat sink that includes a plurality of second heat dissipation fins, and causes cooling air to flow through a second flow path toward the intake opening, the first heat sink and the second heat sink are disposed at different positions in a direction orthogonal to the thickness direction, and the first flow path and the second flow path are spaces different from each other.

As a result of this, the first flow path through which heat exchange is performed by the first heat sink and the second flow path through which heat exchange is performed by the second heat sink are spaces different from each other, and the first flow path and the second flow path up to the intake opening of the cooling fan do not overlap each other.

### BRIEF DESCRIPTION OF DRAWINGS

Fig. 1 illustrates an embodiment of an imaging device according to the present technology in conjunction with Figs. 2 to 14, and this drawing is a perspective view of the imaging device.
Fig. 2 is a perspective view of the imaging device illustrated in a state where a display unit and the like have been removed.
Fig. 3 is a perspective view of the imaging device illustrated as viewed in a direction different from that in Fig. 1.
Fig. 4 is an exploded perspective view illustrating a cooling structure and a control board.
Fig. 5 is a perspective view of the cooling structure.
Fig. 6 is a cross-sectional view of the cooling structure.
Fig. 7 is a rear view illustrating the cooling structure and the like.
Fig. 8 is a conceptual diagram illustrating a flow state of cooling air.
Fig. 9 is a conceptual diagram illustrating an example where cooling air is taken into a case body from an opposite side.
Fig. 10 is a conceptual diagram illustrating an example where cooling air is taken into the case body from sides orthogonal to each other.
Fig. 11 is a conceptual diagram illustrating an example where four heat sinks are provided in the cooling structure.
Fig. 12 is a perspective view illustrating an example of a heat dissipation fin having another shape.
Fig. 13 is a cross-sectional view illustrating an example where two intake openings are formed.
Fig. 14 is a block diagram illustrating an example of the imaging device.

### MODE FOR CARRYING OUT THE INVENTION

A mode for carrying out the present technology is described below with reference to the accompanying drawings.

In the embodiment described below, an imaging device according to the present technology has been applied to a video camera. Note that a range of application of the present technology is not limited to video cameras, and the present technology can be widely applied to, for example, other imaging devices such as still cameras.

In the description below, it is assumed that forward, backward, upward, downward, leftward, and rightward directions are indicated as directions as viewed from an image capturing person. Accordingly, a subject side (an object side) is a front side, and an image capturing person's side (an image side) is a rear side.

Note that the forward, backward, upward, downward, leftward, and rightward directions described below are used for ease of description, and implementation of the present technology is not limited to these directions.

### <Schematic Configuration of Imaging Device>

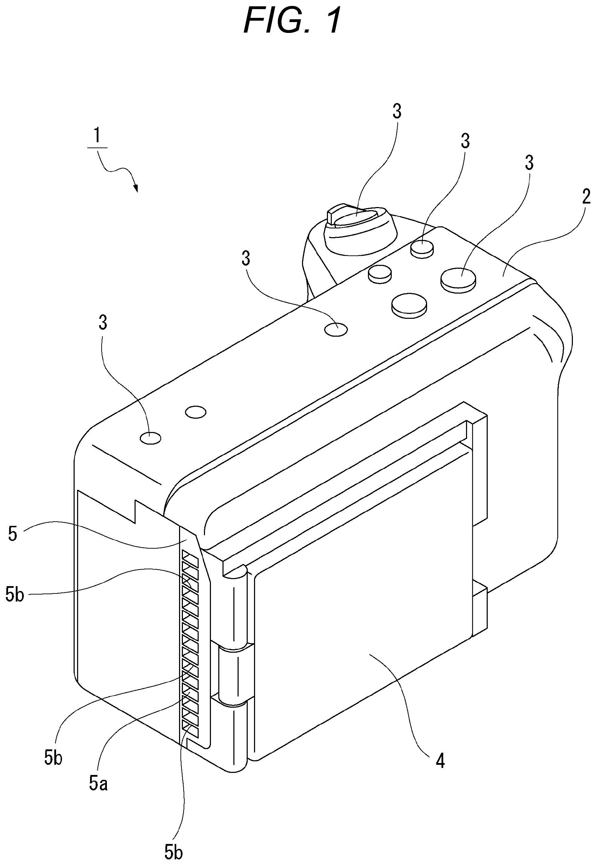

First, a schematic configuration of an imaging device 1 is described (see Figs. 1 to 4). The imaging device 1 includes, for example, an outer casing 2 formed in a horizontally long shape, and respective required units disposed inside the outer casing 2.

In the outer casing 2, a plurality of operation units 3 of various kinds is disposed on, for example, an upper surface, a rear surface, and the like. As the operation units 3, for example, a power button, a shutter button, a zoom knob, a mode switching knob, and the like are provided.

On a front surface portion of the outer casing 2, a not-illustrated opening having a circular shape is formed, and a portion around the opening is provided as a mounting portion for attaching a not-illustrated interchangeable lens. Inside the outer casing 2, a not-illustrated imaging element such as a charge coupled device (CCD) or a complementary metal-oxide semiconductor (CMOS) is disposed, and the imaging element is located behind the opening. The not-illustrated interchangeable lens is attachable to and detachable from the mounting portion.

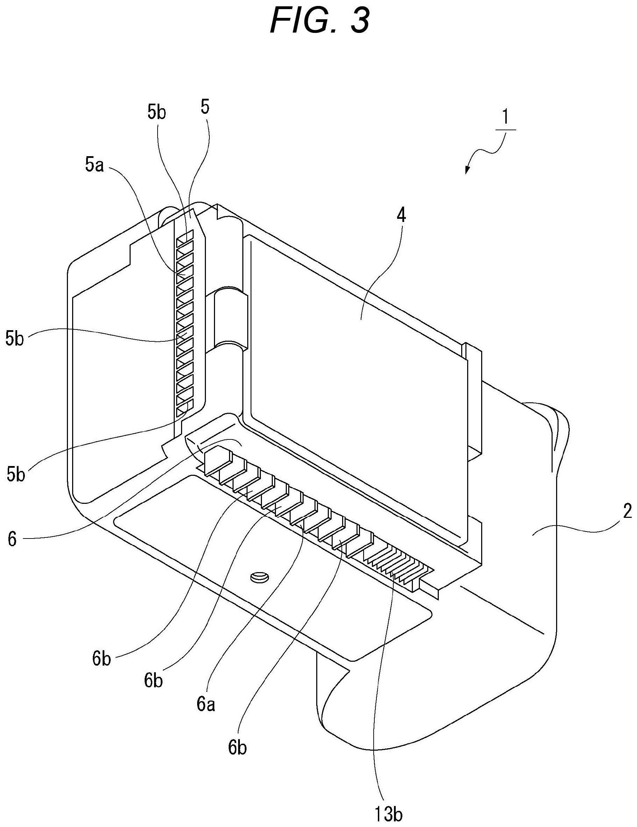

On a rear surface side of the outer casing 2, a display unit 4 including, for example, a liquid crystal display is joined to the outer casing 2 in an openable manner (a rotatable manner) (see Figs. 1 and 3).

A side surface panel 5 is attached to one of the left-hand and right-hand side portions of the outer casing 2 (see Figs. 1 to 3). A blow-out hole 5a having a vertically long shape is formed in a rear end portion of the side surface panel 5. The blow-out hole 5a is partitioned by a plurality of partitions 5b provided to be longitudinally separated from each other. A lower surface panel 6 is attached to a lower end portion of the outer casing 2 (see Fig. 3). An inlet hole 6a having a horizontally long shape is formed in the lower surface panel 6. The inlet hole 6a is partitioned by a plurality of partitions 6b provided to be laterally separated from each other.

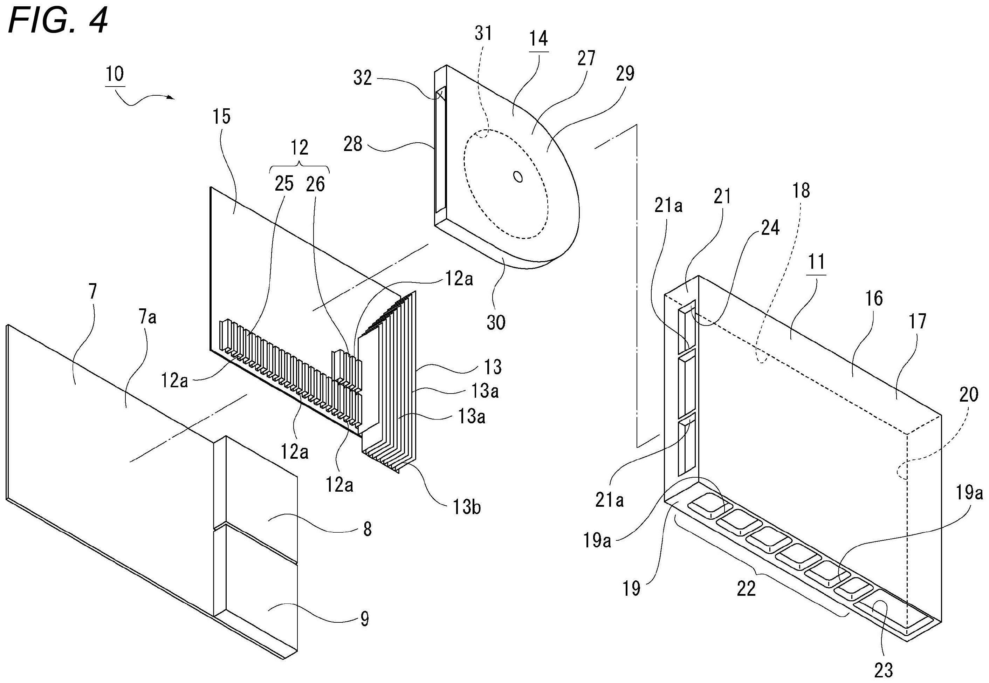

Inside the outer casing 2, a control board 7 that controls the entirety of the imaging device 1 is disposed (see Fig. 4). The control board 7 is formed in, for example, a horizontally long roughly rectangular shape, and is disposed in an orientation facing a forward/backward direction on a rear end side inside the outer casing 2.

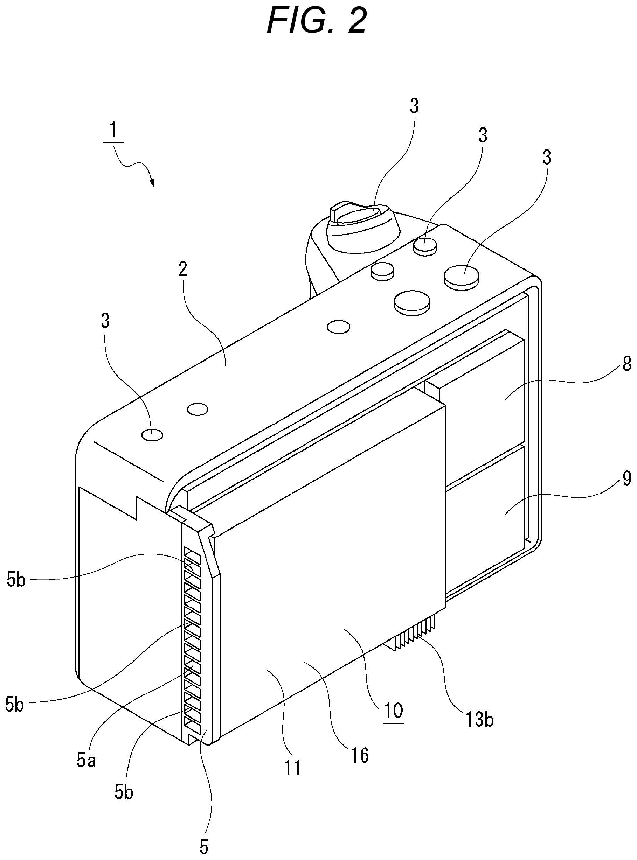

For example, a first card slot 8 and a second card slot 9 are attached to a rear surface of the control board 7 to be longitudinally arranged (see Figs. 2 and 4). The first card slot 8 and the second card slot 9 are attached to a right-hand end portion of the control board 7, and are located on a side of the display unit 4.

In the control board 7, a portion to which the first card slot 8 and the second card slot 9 have not been attached is provided as a mechanism disposition portion 7a, and the mechanism disposition portion 7a is located on a front side of the display unit 4. A plurality of electronic components (not illustrated), such as a semiconductor package or a resistance component, that serves as heat generating elements is mounted on the mechanism disposition portion 7a.

### <Configuration of Cooling Structure>

Next, a cooling structure 10 is described (See Fig. 2 and Figs. 4 to 7).

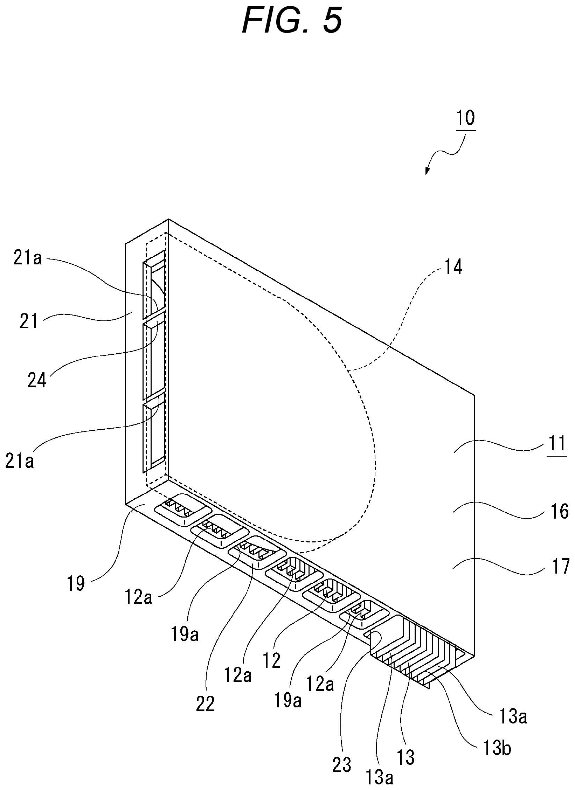

The cooling structure 10 is disposed on a rear surface side of the mechanism disposition portion 7a of the control board 7, and includes a case body 11, a first heat sink 12, a second heat sink 13, and a cooling fan (a centrifugal fan or a sirocco fan) 14 (see Figs. 4 and 5). Each unit of the cooling structure 10 is formed by using a material having high heat dissipation, for example, a metal material.

The case body 11 is formed in, for example, a horizontally long roughly rectangular shape, and includes an attachment plate 15 and a cover 16 that are coupled to each other in the forward/backward direction.

The attachment plate 15 is formed in a horizontally long rectangular shape facing the forward/backward direction, and is a portion that corresponds to a front surface portion of the case body 11.

The cover 16 is formed in a box shape that is open to a front side and one side, and includes a base surface portion 17 facing the forward/backward direction, an upper surface portion 18 protruding forward from an upper edge of the base surface portion 17, a lower surface portion 19 protruding forward from a lower edge of the base surface portion 17, a first side surface portion 20 protruding forward from a right-hand side edge of the base surface portion 17, and a second side surface portion 21 protruding forward from a left-hand side edge of the base surface portion 17.

The base surface portion 17 is a portion that corresponds to a rear surface portion of the case body 11. Accordingly, the base surface portion 17 is formed to have a size and a shape that are roughly the same as those of the attachment plate 15.

In the lower surface portion 19, a first intake hole 22 penetrating longitudinally is formed in a portion excluding a right-hand end portion, and a second intake hole 23 penetrating longitudinally is formed in the right-hand end portion. The first intake hole 22 is partitioned by, for example, a plurality of bridging portions 19a provided to be laterally separated from each other.

In the second side surface portion 21, an exhaust hole 24 penetrating laterally is formed. The exhaust hole 24 is partitioned by, for example, a plurality of bridging portions 21a provided to be longitudinally separated from each other.

The first heat sink 12 includes a plurality of first heat dissipation fins 12a arranged laterally, includes, for example, a first portion 25 and a second portion 26, and is attached to a rear surface of the attachment plate 15. The first heat dissipation fin 12a is formed in, for example, a plate shape extending in the upward/downward direction, or another shape. The first portion 25 and the second portion 26 have, for example, the same size (height) in the forward/backward direction and the same size (length) in the upward/downward direction. However, the first portion 25 and the second portion 26 may be different in height and length from each other. Furthermore, in the imaging device 1, only the first portion 25 may be provided as the first heat sink 12.

The first portion 25 has a width in the leftward/rightward direction that is greater than that of the second portion 26, and is attached to a portion excluding a right-hand end portion of a lower end portion of the attachment plate 15. In the second portion 26, the number of first heat dissipation fins 12a is smaller than that of the first heat sink 12, and the second portion 26 is attached to the attachment plate 15 on an upper side of a right-hand end portion of the first portion 25.

The second heat sink 13 includes a plurality of second heat dissipation fins 13a arranged laterally, and is attached to the rear surface of the attachment plate 15. The second heat dissipation fin 13a is formed in, for example, a plate shape extending in the upward/downward direction, or another shape. Accordingly, the first heat dissipation fins 12a of the first heat sink 12 and the second heat dissipation fins 13a of the second heat sink 13 are in a parallel state.

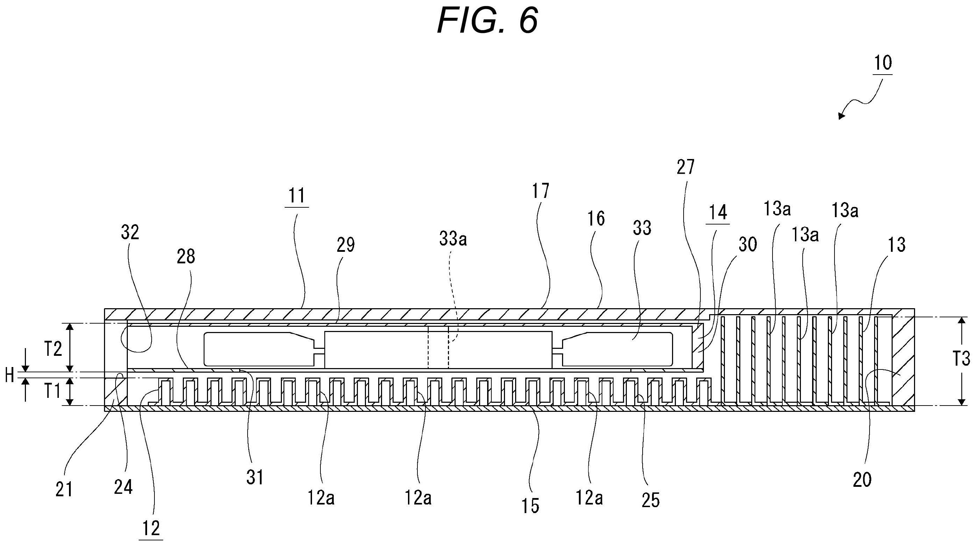

The second heat sink 13 has a height that is greater than the height of the first heat sink 12, and has a length that is greater than the length of the first heat sink 12 (see Figs. 4 and 6). The second heat sink 13 is attached to the right-hand end portion of the attachment plate 15, and for example, a lower end portion protrudes downward from the attachment plate 15. The length of the second heat dissipation fin 13a increases in accordance with a distance from the first heat sink 12 in the leftward/rightward direction. Accordingly, an upper end of the second heat sink 13 is inclined to be displaced downward as approaching the first heat sink 12 in the leftward/rightward direction as a whole.

Note that, in the second heat sink 13, some of the second heat dissipation fins 13a may be different in length.

The cooling fan 14 is formed in a thin and flat shape, and includes a housing 27 functioning as a case, and each predetermined portion disposed inside the housing 27. The housing 27 includes a first surface portion 28 provided as a front surface portion, a second surface portion 29 provided as a rear surface portion, and a peripheral surface portion 30 that corresponds to an outer peripheral portion.

In the first surface portion 28, for example, an intake opening 31 having a circular shape is formed.

The housing 27 is formed in a shape open to the left, and an opening on a left-hand side is formed as an exhaust opening 32. Inside the housing 27, a rotary blade 33 is disposed, and the rotary blade 33 is rotated with a rotary shaft 33a as a fulcrum. An axial direction of the rotary shaft 33a is a thickness direction. The intake opening 31 formed in the housing 27 is formed in a circular shape with the rotary shaft 33a of the rotary blade 33 as a center.

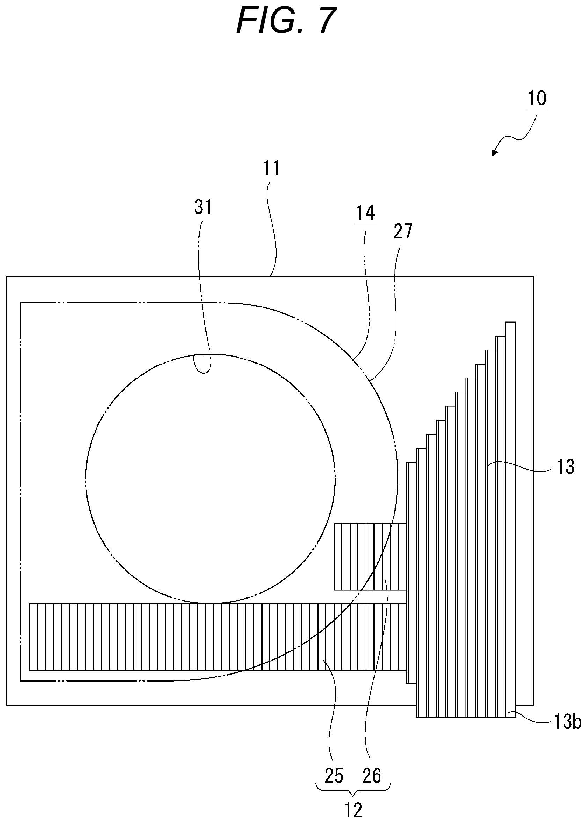

The cooling fan 14 is attached to the rear surface of the attachment plate 15 or a front surface of the base surface portion 17 of the cover 16 on a left-hand side of the second heat sink 13. In a state where the cooling fan 14 has been attached to the attachment plate 15 or the cover 16, a part of the cooling fan 14 overlaps at least a part of the first heat sink 12 from the rear side (see Fig. 7). Specifically, a portion outside the intake opening 31 of the cooling fan 14 overlaps a portion excluding the right-hand end portion of the first portion 25 and a portion excluding the right-hand end portion of the second portion 26 to face each other. Accordingly, the intake opening 31 of the cooling fan 14 does not overlap the first heat sink 12.

In a state where the first heat sink 12, the second heat sink 13, and the cooling fan 14 have been attached to the case body 11, the sum of the height T1 of the first heat sink 12 and the thickness T2 of the cooling fan is less than or equal to the height T3 of the second heat sink 13 (see Fig. 6).

By setting the sum of the height T1 of the first heat sink 12 and the thickness T2 of the cooling fan to be less than or equal to the height T3 of the second heat sink 13, as described above, the thickness of the cooling structure 10 can be made less than or equal to a certain value, and the cooling structure 10 and the imaging device 1 can be thinned.

Note that the cooling fan 14 and the first heat sink 12 partially face each other in the thickness direction, but a slight gap H may be formed between the cooling fan 14 and the first heat sink 12. In this case, the sum of the height T1 of the first heat sink 12, the thickness T2 of the cooling fan, and the gap H is set to be less than or equal to the height T3 of the second heat sink 13, and also in this case, the thickness of the cooling structure 10 can be set to be less than or equal to a certain value, and the cooling structure 10 and the imaging device 1 can be thinned.

Furthermore, at least a part of the first heat sink 12 and a part of the first surface portion 28 of the cooling fan 14 face each other in the thickness direction.

Accordingly, at least a part of the first heat sink 12 and a part of the cooling fan 14 are located to overlap each other in the thickness direction, and thus an outer shape orthogonal to the thickness direction of the cooling structure 10 can be reduced in size.

Moreover, the second heat sink 13 is located outside the outer periphery of the cooling fan 14, and the first heat sink 12 is located outside the intake opening 31, and thus both the first heat sink 12 and the second heat sink 13 are located outside the intake opening 31 of the cooling fan 14, and high cooling-air intake performance of the cooling fan 14 can be secured. Furthermore, the second heat sink 13 does not overlap the cooling fan 14 in the thickness direction, and thus the height of the second heat dissipation fin 13a can be increased to increase the heat dissipation area, and cooling efficiency can be improved.

In a state where the first heat sink 12, the second heat sink 13, and the cooling fan 14 are disposed at respective predetermined positions, as described above, the attachment plate 15 and the cover 16 are coupled to form the cooling structure 10 (see Fig. 5).

The cooling structure 10 disposed on a rear surface side of the mechanism disposition portion 7a in the control board 7 is located on a side of the first card slot 8 and the second card slot 9. Furthermore, in the cooling structure 10, the first heat sink 12 is located directly above the first intake hole 22 of the case body 11, and the second heat sink 13 excluding a part thereof is located directly above the second intake hole 23 of the case body 11. In the first heat sink 12, the first portion 25 is located close to the first intake hole 22, and the second portion 26 is located on an opposite side of the first intake hole 22 across the first portion 25.

In the cooling structure 10, the lower end portion of the second heat sink 13 protrudes downward from the second intake hole 23. Accordingly, the lower end portion of the second heat sink 13 is provided as a protrusion 13b. However, in the cooling structure 10, a part of the second heat sink 13 does not necessarily need to protrude downward from the second intake hole 23.

In a state where the cooling structure 10 is disposed on the rear surface side of the mechanism disposition portion 7a, for example, an imaging element or the like is connected to the cooling structure 10 by using a heat transfer body such as a graphite sheet or a copper thin plate (not illustrated). Furthermore, heat generating components, such as electronic components, that have been mounted on the control board 7 are in contact with or close to the attachment plate 15 of the case body 11. Note that the heat generating components, such as electronic components, that have been mounted on the control board 7 may also be connected to the cooling structure 10 by using the heat transfer body such as a graphite sheet or a copper thin plate.

Accordingly, heat generated in the heat generating components can be transferred to the cooling structure 10 by using the heat transfer body. The imaging device 1 has, in particular, a configuration in which the heat of the imaging element is mainly transferred to the first heat sink 12 and the heat of the heat generating components mounted on the control board 7 is mainly transferred to the second heat sink 13, the first heat sink 12 mainly has a role of restraining a rise in temperature of the imaging element, and the second heat sink 13 mainly has a role of restraining a rise in temperature of the heat generating components mounted on the control board 7.

Note that, in the imaging device 1, for example, the second heat sink 13 may have a role of restraining a rise in temperature of the first card slot 8 and the second card slot 9 in addition to the role of restraining a temperature rise of the heat generating components mounted on the control board 7.

Furthermore, the imaging device 1 may be configured in such a way that at least a part of heat generated in each of the heat generating components described above is transferred to the outer casing 2, and is also dissipated from the outer casing 2.

### <Flow Path of Cooling Air>

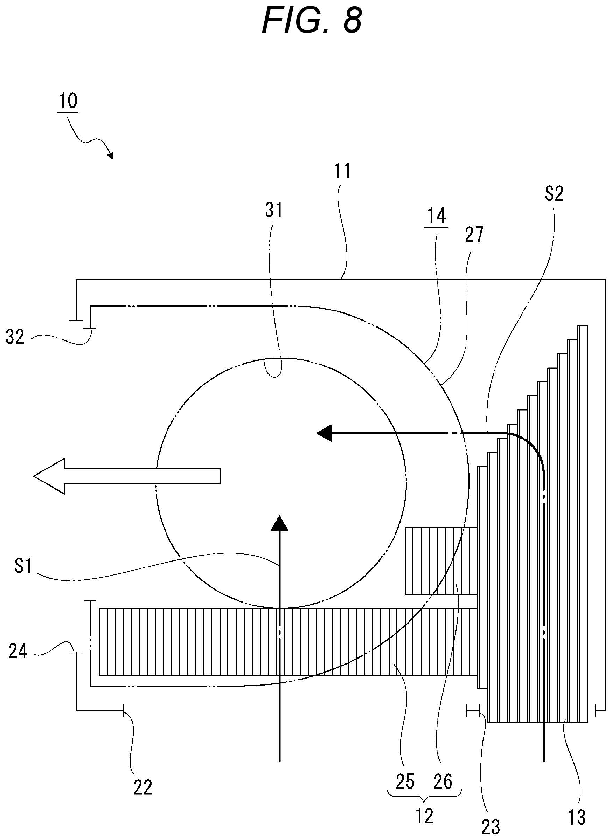

A flow path of cooling air in the cooling structure 10 is described below (see Fig. 8).

In the imaging device 1, in accordance with rotation of the rotary blade of the cooling fan 14, air existing outside the imaging device 1 is taken in as cooling air from the first intake hole 22 and the second intake hole 23 of the case body 11 via the inlet hole 6a of the lower surface panel 6.

The cooling air taken in from the first intake hole 22 passes through a space between the plurality of first heat dissipation fins 12a of the first heat sink 12, and is sucked into the cooling fan 14 from the intake opening 31. A flow path from the first intake hole 22 through the space between the plurality of first heat dissipation fins 12a to the intake opening 31 is a first flow path S1. At this time, heat that has been transferred to the first heat sink 12 is dissipated, and heat is exchanged with the cooling air passing through the first flow path S1.

The cooling air taken in from the second intake hole 23 passes through a space between the plurality of second heat dissipation fins 13a of the second heat sink 13, and is sucked into the cooling fan 14 from the intake opening 31. A flow path from the second intake hole 23 through the space between the plurality of second heat dissipation fins 13a to the intake opening 31 is a second flow path S2. At this time, heat that has been transferred to the second heat sink 13 is dissipated, and heat is exchanged with the cooling air passing through the second flow path S2.

As described above, in the cooling structure 10, the flow path from the first intake hole 22 through the space between the first heat dissipation fins 12a to the intake opening 31 is the first flow path S1, and the flow path from the second intake hole 23 through the space between the second heat dissipation fins 13a to the intake opening 31 is the second flow path S2, and thus the first flow path S1 and the second flow path S2 are spaces different from each other.

The cooling air that has passed through the first flow path S1 and the second flow path S2 and has increased in temperature due to heat exchange passes through the inside of the cooling fan 14, is blown out from the exhaust opening 32, and is discharged from the blow-out hole 5a of the side surface panel 5 to the outside of the imaging device 1 via the exhaust hole 24 of the case body 11. Accordingly, a rise in temperature of heat generating components, such as the imaging element or the electronic components of the control board 7, is restrained.

### <Conclusion>

As described above, the imaging device 1 includes the cooling fan 14 in which the intake opening 31 is formed, the first heat sink 12 that causes cooling air to flow through the first flow path S1, and the second heat sink 13 that causes the cooling air to flow through the second flow path S2, the first heat sink 12 and the second heat sink 13 are disposed at different positions in a direction orthogonal to the thickness direction, and the first flow path S1 and the second flow path S2 are spaces different from each other.

Accordingly, the first flow path S1 through which heat exchange is performed by the first heat sink 12 and the second flow path S2 through which heat exchange is performed by the second heat sink 13 are spaces different from each other, and the first flow path S1 and the second flow path S2 up to the intake opening 31 of the cooling fan 14 do not overlap each other. As a result of this, the cooling air caused to flow through the first flow path S1 and the cooling air caused to flow through the second flow path S2 do not affect each other, and thus cooling efficiency can be improved without an increase in size of components.

Furthermore, the gap H is formed between the first heat sink 12 and the cooling fan 14, and thus a flow path of the cooling air caused to flow through the first flow path S1 is formed between the first heat sink 12 and the cooling fan 14, the fluidity of the cooling air to the intake opening 31 increases, and cooling efficiency can be improved.

Moreover, in the case body 11, the first intake hole 22 of cooling air flowing toward the first flow path S1 and the second intake hole 23 of cooling air flowing toward the second flow path S2 are formed, and the first intake hole 22 and the second intake hole 23 are formed in the same surface portion (the lower surface portion 19) of the case body 11.

Accordingly, the cooling air flowing toward the first flow path S1 and the cooling air flowing toward the second flow path S2 are taken in from the same side, and thus a flow path of the cooling air can be easily designed in the entirety of the imaging device 1.

Furthermore, the first heat sink 12 includes the first portion 25 and the second portion 26 that are different in the number of first heat dissipation fins 12a, and the second portion 26 is located on an opposite side of the first intake hole 22 across the first portion 25.

Accordingly, the first portion 25 and the second portion 26 cause an increase in the number of first heat dissipation fins 12a of the first heat sink 12, and thus cooling efficiency can be improved.

Furthermore, the number of first heat dissipation fins 12a of the first portion 25 is larger than the number of first heat dissipation fins 12a of the second portion 26.

Accordingly, the first portion 25 having a larger number of first heat dissipation fins 12a is disposed at a position closer to the first intake hole 22 than the second portion 26, and thus the number of first heat dissipation fins 12a can be increased without interfering with the position of the cooling fan 14, and cooling efficiency can be improved while securing a reduction in size of the imaging device 1.

Moreover, a part (the protrusion 13b) of the second heat sink 13 protrudes outward from the second intake hole 23, and thus the length of the second heat dissipation fin 13a increases, and the cooling efficiency of the second heat sink 13 can be improved.

Furthermore, the first heat dissipation fins 12a and the second heat dissipation fins 13a are located in a parallel state, and thus cooling air caused to flow through the first flow path S1 and cooling air caused to flow through the second flow path S2 are not mixed, and cooling efficiency can be improved.

In addition, the case body 11 is located to face the control board 7 in the thickness direction, and from among both surface portions in the thickness direction of the cooling fan 14, the first surface portion 28 is located closer to the control board 7 than the second surface portion 29.

Accordingly, the intake opening 31 formed in the first surface portion 28 is located on a side of the control board 7, and thus the intake opening 31 is located on a side close to the heat generating components mounted on the control board 7, and high cooling efficiency with respect to the heat generating components can be secured.

### <Others>

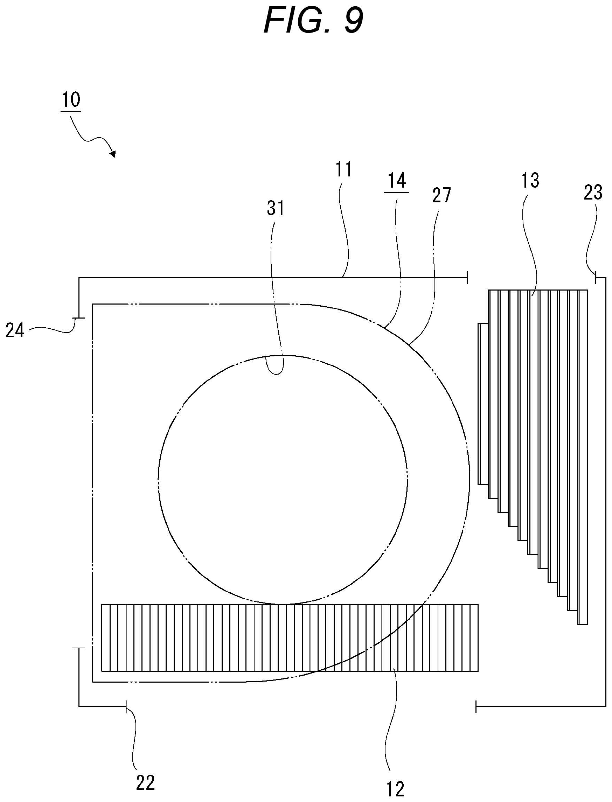

Other configurations of the cooling structure 10 are described below (see Figs. 9 to 12).

In the description above, an example has been described where both cooling air caused to flow through the first flow path S1 and cooling air caused to flow through the second flow path S2 are taken into the case body 11 from the same side (a lower side), but it is also possible to adopt a configuration in which both types of cooling air are taken into the case body 11 from different sides.

For example, it is possible to adopt a configuration in which both types of cooling air are taken into the case body 11 from opposite sides in the upward/downward direction or the leftward/rightward direction (see Fig. 9). In this case, for example, the first intake hole 22 is formed in the lower surface portion 19 of the case body 11, and the second intake hole 23 is formed in the upper surface portion 18 of the case body 11.

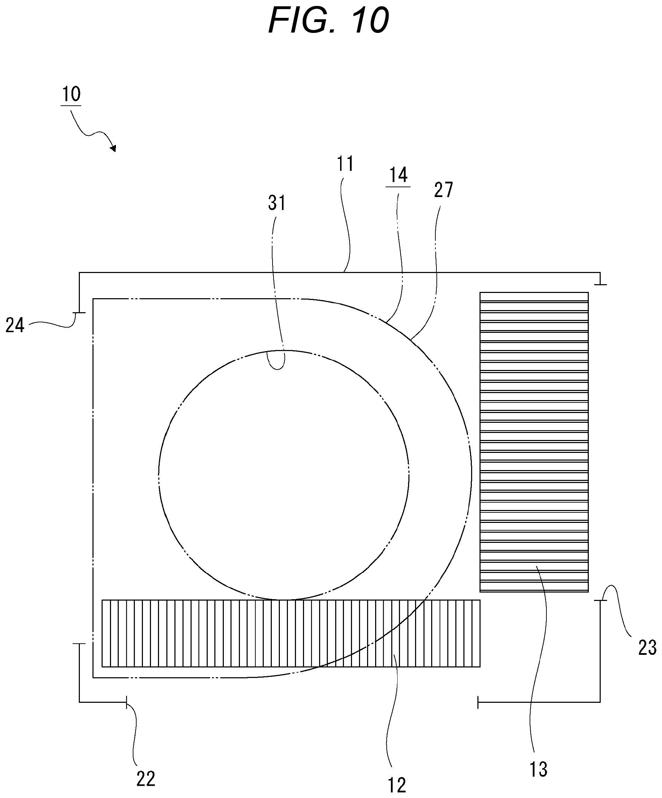

Furthermore, for example, it is also possible to adopt a configuration in which both types of cooling air are taken into the case body 11 from sides orthogonal to each other (see Fig. 10). In this case, for example, the first intake hole 22 is formed in the lower surface portion 19 of the case body 11, and the second intake hole 23 is formed in the first side surface portion 20 of the case body 11.

Also in a configuration in which both types of cooling air are taken into the case body 11 from different sides, as described above, the first flow path S1 and the second flow path S2 are spaces different from each other, and thus cooling efficiency can be improved.

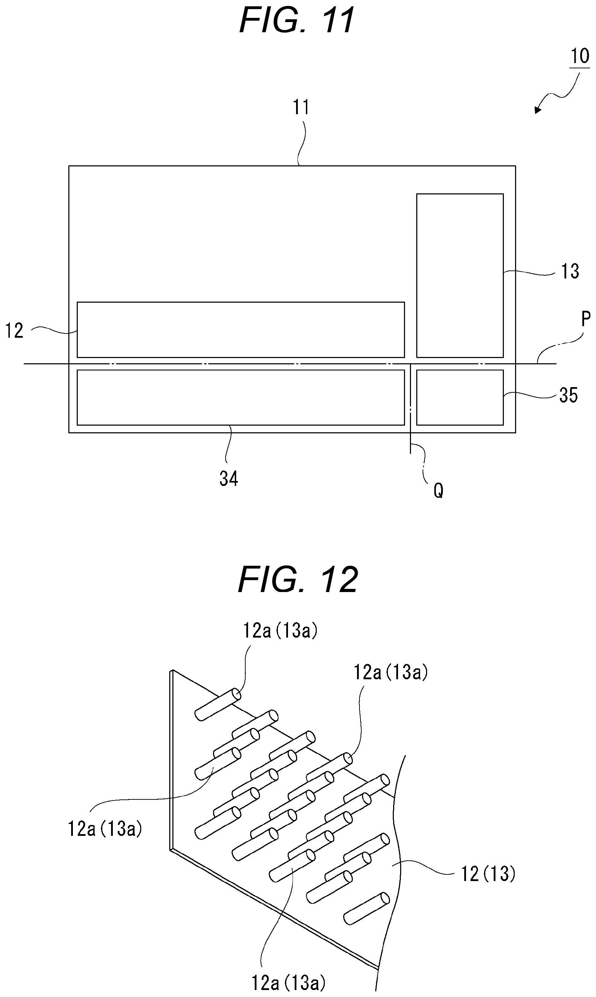

Furthermore, although an example of a configuration in which the first heat sink 12 and the second heat sink 13 are provided in the cooling structure 10 has been described above, three or more heat sinks may be provided in the cooling structure 10 (see Fig. 11).

For example, the cooling structure 10 may be provided with a third heat sink 34 in addition to the first heat sink 12 and the second heat sink 13, or may be provided with the third heat sink 34 and a fourth heat sink 35 in addition to the first heat sink 12 and the second heat sink 13. Note that, in this case, the case body 11 may be divided at portions where the third heat sink 34 and the fourth heat sink 35 are respectively present, and may include three portions (see line segments P and Q in Fig. 11). Furthermore, the case body 11 may be divided only along line segment P, and may include two portions.

In a configuration in which the first heat sink 12, the second heat sink 13, the third heat sink 34, and the fourth heat sink 35 are provided, for example, it is possible to adopt a configuration in which the first heat sink 12 and the second heat sink 13 mainly have a role of restraining a rise in temperature of each heat generating component such as an electronic component mounted on the control board 7, the third heat sink 34 has a role of restraining a rise in temperature of the imaging element, and the fourth heat sink 35 mainly has a role of restraining a rise in temperature of the first card slot 8 and the second card slot 9.

By adopting such a configuration of the cooling structure 10, it is possible to efficiently restrain a rise in temperature of various heat generating components in the imaging device 1, and cooling efficiency can be further improved.

Moreover, in the description above, an example has been described where both the first heat dissipation fins 12a of the first heat sink 12 and the second heat dissipation fins 13a of the second heat sink 13 are formed in a plate shape or the like, but the first heat dissipation fins 12a and the second heat dissipation fins 13a may be formed in, for example, a shaft shape, a pin shape, or the like (see Fig. 12).

Note that, in the imaging device 1, heat dissipation fins of the third heat sink 34 or the fourth heat sink 35 may also have a plate shape or the like, or may have a shaft shape, a pin shape, or the like.

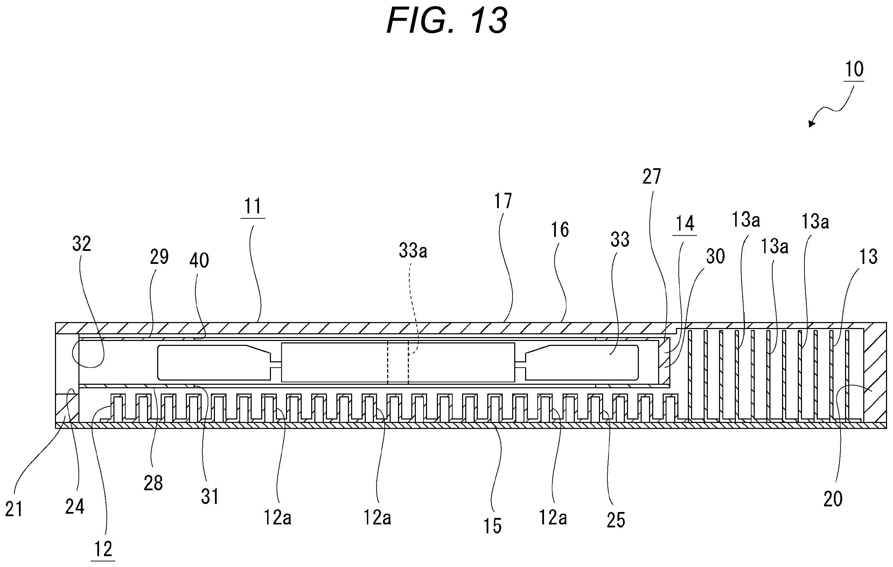

Furthermore, in the description above, an example has been described where the intake opening 31 is formed in the first surface portion 28 serving as one surface portion of the cooling fan 14, but in the cooling fan 14, an intake opening 40 may also be formed in a surface portion other than the first surface portion 28, for example, the second surface portion 29 (see Fig. 13). In this case, cooling air is also taken into the cooling fan 14 from the intake opening 40 through a space between the base surface portion 17 and the second surface portion 29 of the case body 11, and thus cooling efficiency can be further improved.

### <Embodiment of Imaging Device>

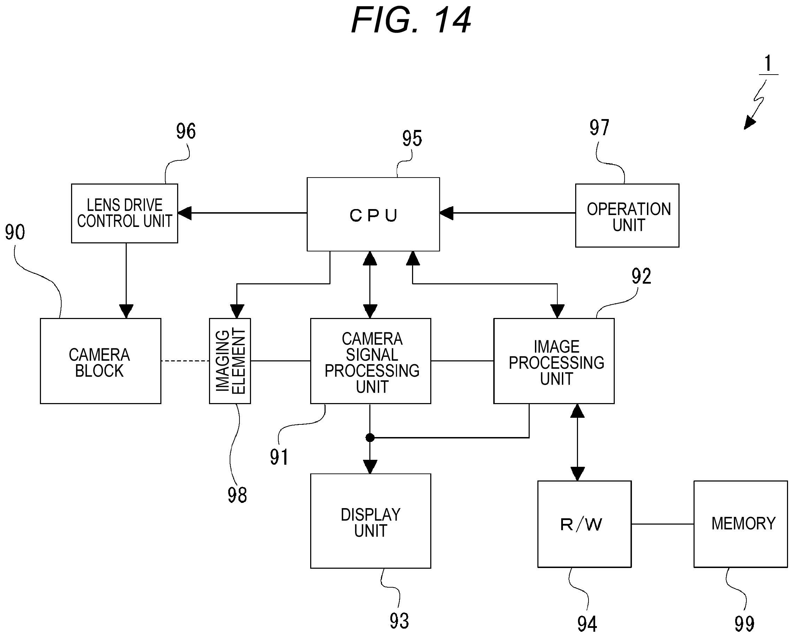

A configuration example of an embodiment of the imaging device 1 is described below (see Fig. 14).

The imaging device 1 is equipped with a camera block 90 having an imaging function, and includes: a camera signal processing unit 91 that performs signal processing such as analog-digital conversion on a captured image signal; and an image processing unit 92 that performs a recording/reproducing process on the image signal. Furthermore, the imaging device 1 includes: a display unit 93 (the display unit 4) that displays a captured image or the like; a reader/writer (R/W) 94 that writes and reads an image signal to and from a memory 99; a central processing unit (CPU) 95 that controls the entirety of the imaging device 1; a lens drive control unit 96 that controls driving of a lens disposed in the camera block 90; and an operation unit 97 (the operation units 3), such as various switches, on which a user performs a required operation.

The camera block 90 is, for example, an interchangeable lens.

The imaging device 1 is provided with an imaging element 98, such as a CCD or a CMOS, that converts an optical image captured by the camera block 90 into an electrical signal.

The camera signal processing unit 91 performs various kinds of signal processing, such as conversion into a digital signal, noise removal, image quality correction, or conversion into a luminance and colordifference signal, on an output signal from the imaging element 98.

The image processing unit 92 performs a compression encoding and decompression decoding process, a process of converting data specifications such as resolution, or the like on an image signal based on a predetermined image data format.

The display unit 93 has a function of displaying various kinds of data such as a state of an operation performed on the operation unit 97 by a user or a captured image. Note that the imaging device 1 does not necessarily need to be provided with the display unit 93, and may be configured in such a way that captured image data is transmitted to another display device and an image is displayed.

The R/W 94 writes image data encoded by the image processing unit 92 to the memory 99, and reads image data recorded in the memory 99.

The CPU 95 functions as a control processing unit that controls each circuit block provided in the imaging device 1, and controls each of the circuit blocks on the basis of an instruction input signal or the like from the operation unit 97.

The lens drive control unit 96 controls a drive source that moves the lens on the basis of a control signal from the CPU 95.

The operation unit 97 outputs, to the CPU 95, an instruction input signal in response to an operation performed by the user.

The memory 99 is, for example, a semiconductor memory attachable to and detachable from a slot connected to the R/W 94, or a semiconductor memory incorporated in advance into the imaging device 1.

An operation of the imaging device 1 is described below.

In a standby state for imaging, under the control of the CPU 95, a captured image signal is output to the display unit 93 via the camera signal processing unit 91, and is displayed as a through-the-camera image. Furthermore, when an instruction input signal from the operation unit 97 has been input, the CPU 95 outputs a control signal to the lens drive control unit 96, and the lens is moved on the basis of control performed by the lens drive control unit 96.

When an imaging operation has been performed in accordance with the instruction input signal from the operation unit 97, a captured image signal is output from the camera signal processing unit 91 to the image processing unit 92, is subjected to a compression encoding process, and is converted into digital data in a predetermined data format. The converted data is output to the R/W 94, and is written to the memory 99.

In a case where the image data recorded in the memory 99 is reproduced, predetermined image data is read from the memory 99 by the R/W 94 in response to an operation performed on the operation unit 97, a decompression decoding process is performed by the image processing unit 92, and then, a reproduced image signal is output to the display unit 93, and a reproduced image is displayed.

Note that, in the present technology, "imaging" refers to processing including only some of or all of a series of processes including a photoelectric conversion process performed by the imaging element 98 for converting captured light into an electric signal, a process, such as conversion into a digital signal, noise removal, image quality correction, or conversion into a luminance/color-difference signal, that is performed on an output signal from the imaging element 98 by the camera signal processing unit 91, a compression encoding and decompression decoding process or a process of converting data specifications such as resolution that is performed on an image signal based on a predetermined image data format by the image processing unit 92, and a process performed by the R/W 94 for writing an image signal to the memory 99.

Stated another way, "imaging" may only refer to the photoelectric conversion process performed by the imaging element 98 for converting captured light into an electric signal, may refer to processing from the photoelectric conversion process performed by the imaging element 98 for converting captured light into an electric signal to the process, such as conversion into a digital signal, noise removal, image quality correction, or conversion into a luminance/color-difference signal, that is performed on an output signal from the imaging element 98 by the camera signal processing unit 91, may refer to processing from the photoelectric conversion process performed by the imaging element 98 for converting captured light into an electric signal via the process, such as conversion into a digital signal, noise removal, image quality correction, or conversion into a luminance/color-difference signal, that is performed on an output signal from the imaging element 98 by the camera signal processing unit 91 to the compression encoding and decompression decoding process or the process of converting data specifications such as resolution that is performed on an image signal based on a predetermined image data format by the image processing unit 92, may refer to processing from the photoelectric conversion process performed by the imaging element 98 for converting captured light into an electric signal to the process, such as conversion into a digital signal, noise removal, image quality correction, or conversion into a luminance/color-difference signal, that is performed on an output signal from the imaging element 98 by the camera signal processing unit 91, and the compression encoding and decompression decoding process or the process of converting data specifications such as resolution that is performed on an image signal based on a predetermined image data format by the image processing unit 92, or may refer to processing up to the process performed by the R/W 94 for writing an image signal to the memory 99.

### <Present Technology>

The present technology can also be configured as described below.
(1) An imaging device including:
   a cooling fan in which a rotary blade is disposed inside a housing, an axial direction of a rotary shaft of the rotary blade is a thickness direction, and an intake opening is formed on at least one surface portion in the thickness direction;
   a first heat sink that includes a plurality of first heat dissipation fins, and causes cooling air to flow through a first flow path toward the intake opening; and
   a second heat sink that includes a plurality of second heat dissipation fins, and causes cooling air to flow through a second flow path toward the intake opening,
   in which the first heat sink and the second heat sink are disposed at different positions in a direction orthogonal to the thickness direction, and
   the first flow path and the second flow path are spaces different from each other.
(2) The imaging device according to (1),
   in which at least a part of the first heat sink and a part of the one surface portion of the cooling fan face each other in the thickness direction.
(3) The imaging device according to (2),
   in which the second heat sink is located outside an outer periphery of the cooling fan, and
   the first heat sink is located outside the intake opening.
(4) The imaging device according to (2),
   in which a sum of a height of the first heat sink and a thickness of the cooling fan in the thickness direction is less than or equal to a height of the second heat sink in the thickness direction.
(5) The imaging device according to (2),
   in which a gap is formed between the first heat sink and the cooling fan.
(6) The imaging device according to any of (1) to (5),
   in which a case body is provided, at least a part of each of the cooling fan, the first heat sink, and the second heat sink being disposed in the case body,
   a first intake hole and a second intake hole are formed in the case body, the first intake hole taking in the cooling air that is caused to flow through the first flow path, the second intake hole taking in the cooling air that is caused to flow through the second flow path, and
   the first intake hole and the second intake hole are formed on an identical surface portion of the case body.
(7) The imaging device according to (6),
   in which the first heat sink includes a first portion and a second portion that are different in a number of the plurality of first heat dissipation fins, and
   the second portion is located on an opposite side of the first intake hole across the first portion.
(8) The imaging device according to (7),
   in which the number of the plurality of first heat dissipation fins of the first portion is larger than the number of the plurality of first heat dissipation fins of the second portion.
(9) The imaging device according to (6),
   in which a part of the second heat sink protrudes outward from the second intake hole.
(10) The imaging device according to any of (1) to (5),
   in which the plurality of first heat dissipation fins and the plurality of second heat dissipation fins are located in a parallel state.
(11) The imaging device according to (6),
   in which the case body is located to face a control board in the thickness direction, and
   from among both surface portions in the thickness direction of the cooling fan, the one surface portion is located closer to the control board than another surface portion.

### REFERENCE SIGNS LIST

- 1: Imaging device
- 7: Control board
- 11: Case body
- 12: First heat sink
- 12a: First heat dissipation fin
- 13: Second heat sink
- 13a: Second heat dissipation fin
- 14: Cooling fan
- 22: First intake hole
- 23: Second intake hole
- 25: First portion
- 26: Second portion
- 27: Housing
- 31: Intake opening
- 33: Gap
- 40: Intake opening
- S1: First flow path
- S2: Second flow path

## Claims

1. An imaging device comprising:
a cooling fan in which a rotary blade is disposed inside a housing, an axial direction of a rotary shaft of the rotary blade is a thickness direction, and an intake opening is formed on at least one surface portion in the thickness direction;
a first heat sink that includes a plurality of first heat dissipation fins, and causes cooling air to flow through a first flow path toward the intake opening; and
a second heat sink that includes a plurality of second heat dissipation fins, and causes cooling air to flow through a second flow path toward the intake opening,
wherein the first heat sink and the second heat sink are disposed at different positions in a direction orthogonal to the thickness direction, and
the first flow path and the second flow path are spaces different from each other.

2. The imaging device according to claim 1,
wherein at least a part of the first heat sink and a part of the one surface portion of the cooling fan face each other in the thickness direction.

3. The imaging device according to claim 2,
wherein the second heat sink is located outside an outer periphery of the cooling fan, and
the first heat sink is located outside the intake opening.

4. The imaging device according to claim 2,
wherein a sum of a height of the first heat sink and a thickness of the cooling fan in the thickness direction is less than or equal to a height of the second heat sink in the thickness direction.

5. The imaging device according to claim 2,
wherein a gap is formed between the first heat sink and the cooling fan.

6. The imaging device according to claim 1,
wherein a case body is provided, at least a part of each of the cooling fan, the first heat sink, and the second heat sink being disposed in the case body,
a first intake hole and a second intake hole are formed in the case body, the first intake hole taking in the cooling air that is caused to flow through the first flow path, the second intake hole taking in the cooling air that is caused to flow through the second flow path, and
the first intake hole and the second intake hole are formed on an identical surface portion of the case body.

7. The imaging device according to claim 6,
wherein the first heat sink includes a first portion and a second portion that are different in a number of the plurality of first heat dissipation fins, and
the second portion is located on an opposite side of the first intake hole across the first portion.

8. The imaging device according to claim 7,
wherein the number of the plurality of first heat dissipation fins of the first portion is larger than the number of the plurality of first heat dissipation fins of the second portion.

9. The imaging device according to claim 6,
wherein a part of the second heat sink protrudes outward from the second intake hole.

10. The imaging device according to claim 1,
wherein the plurality of first heat dissipation fins and the plurality of second heat dissipation fins are located in a parallel state.

11. The imaging device according to claim 6,
wherein the case body is located to face a control board in the thickness direction, and
from among both surface portions in the thickness direction of the cooling fan, the one surface portion is located closer to the control board than another surface portion.
